# EUROPEAN PATENT APPLICATION

(11) **EP 2 947 310 A1**
(43) Date of publication of application: **25.11.2015**
(21) Application number: 15168243.2
(22) Date of filing: 19.05.2015
(51) Int. Cl.: F02P 19/02, H03K 17/16, F02D 41/28

(54) **ENERGIZATION CONTROL APPARATUS FOR A GLOW PLUG**

(30) Priority: 19.05.2014 JP 2014103142; 14.05.2015 JP 2015099271
(71) Applicant: NGK Spark Plug Co., Ltd., Nagoya-shi, Aichi 467-8525 (JP)
(72) Inventor: Toda, Satoru, Nagoya, Aichi 467-8525 (JP); Kumazawa, Shinji, Nagoya, Aichi 467-8525 (JP)
(74) Representative: Grünecker Patent- und Rechtsanwälte PartG mbB

(57) **Abstract**

An energization control apparatus (100) has a semiconductor switching element (22) disposed between a power supply (300, BAT) and a glow plug (200) and controlling the supply and cutoff of electric power from the power supply to the glow plug (200) in accordance with a received control signal (S1). The energization control apparatus has a capacitor (11) connected in parallel to the semiconductor switching element (22), so as to suppress the influence of noise on other devices.

## Description

### [Technical Field]

The present invention relates to an energization control apparatus for controlling the supply of electric power from a power supply to a glow plug.

### [Background Art]

Conventionally, there has been used an energization control apparatus which has a semiconductor switching element such as an FET (Field Effect Transistor), an IGBT (Insulated Gate Bipolar Transistor), or the like so as to control the supply of electricity to a glow plug used for, for example, assisting the ignition of fuel in a diesel engine (see Patent Document 1). In such an energization control apparatus, a semiconductor switching element is operated on the basis of a control signal supplied from, for example, a vehicle-mounted ECU (Electronic Control Unit), whereby the supply of electricity to the glow plug is controlled.

### [Prior Art Document]

### [Patent Document]

[Patent Document 1] Japanese Patent Application Laid-Open (*kokai*) No. 2011-38654

### [Summary of the Invention]

### [Problem to be Solved by the Invention]

Variation of a power supply voltage at the time of switching of the semiconductor switching element between on and off states may affect, as noise, other devices (an FM radio, a microcomputer, etc. mounted on the vehicle) connected to the power supply. Therefore, there has been demand for an energization control apparatus for a glow plug which can suppress the influence of noise on other devices.

### [Means for Solving the Problem]

The present invention has been made in order to solve the above problem and can be embodied in the following modes.
(1) According to one mode of the present invention, there is provided an energization control apparatus which has a semiconductor switching element disposed between a power supply and a glow plug and controlling the supply and cutoff of electric power from the power supply to the glow plug in accordance with a received control signal. This energization control apparatus includes a capacitor connected in parallel to the semiconductor switching element. The energization control apparatus of this mode has a capacitor connected in parallel to the semiconductor switching element. By means of the capacitor, the variation of the power supply voltage can be shifted to the low frequency side. In general, the higher the frequency, the lower the level of the variation of the power supply voltage. Therefore, the level of the variation of the power supply voltage can be lowered in each frequency band by shifting the variation of the power supply voltage to the low frequency side as a whole (in other words, while maintaining the level differences between frequencies). Therefore, the influence of the variation (noise) of the power supply voltage on other devices can be suppressed. As described above, the energization control apparatus of the above-described mode can suppress the influence of noise on other devices.
(2) The energization control apparatus of the above-described mode may further include a correction circuit, wherein the correction circuit corrects the control signal in such a manner that a rise time of the corrected control signal input to the semiconductor switching element becomes shorter than that of the control signal before the correction, or a fall time of the corrected control signal input to the semiconductor switching element becomes shorter than that of the control signal before the correction. Since the energization control apparatus of this mode has such a correction circuit, an increase in the amount of heat generated by the semiconductor switching element and malfunction can be suppressed.
(3) In the energization control apparatus of the above-described mode, the semiconductor switching element and the capacitor may be connected in series to a plurality of the glow plugs connected in parallel to one another. The energization control apparatus of this mode can suppress the influence of noise on other devices when energization of a plurality of glow plugs is controlled.
(4) The energization control apparatus of the above-described mode may further include a resistor which is connected in series to the capacitor and which has a resistance of 1 ohm or less. The energization control apparatus of this mode can attenuate the variation of the power supply voltage by using the resistor as a damping resistor.

The present invention can be embodied in various modes different from the above modes. For example, the present invention can be embodied as a method of supplying electric power to a glow plug, an ignition system including a glow plug, etc.

### [Brief Description of the Drawings]

[FIG. 1] Electrical circuit diagram showing the configuration of an energization control apparatus according to one embodiment of the present invention.
[FIG. 2] Explanatory graph showing the amount of variation (the level of transmission noise) of power supply voltage which occurs in the energization control apparatus 100 of the present embodiment.
[FIG. 3] Explanatory graph showing the amount of variation (the level of transmission noise) of power supply voltage which occurs in an energization control apparatus of a comparative example.
[FIG. 4] Explanatory diagram showing another application example of the energization control apparatus 100 of the first embodiment.
[FIG. 5] Electrical circuit diagram showing the configuration of an energization control apparatus 100a according to a second embodiment.
[FIG. 6] Explanatory diagram showing the configuration of a power supply variation frequency shift circuit in a modification.

### [Modes for Carrying out the Invention]

### A. First embodiment:

### A1. Apparatus configuration:

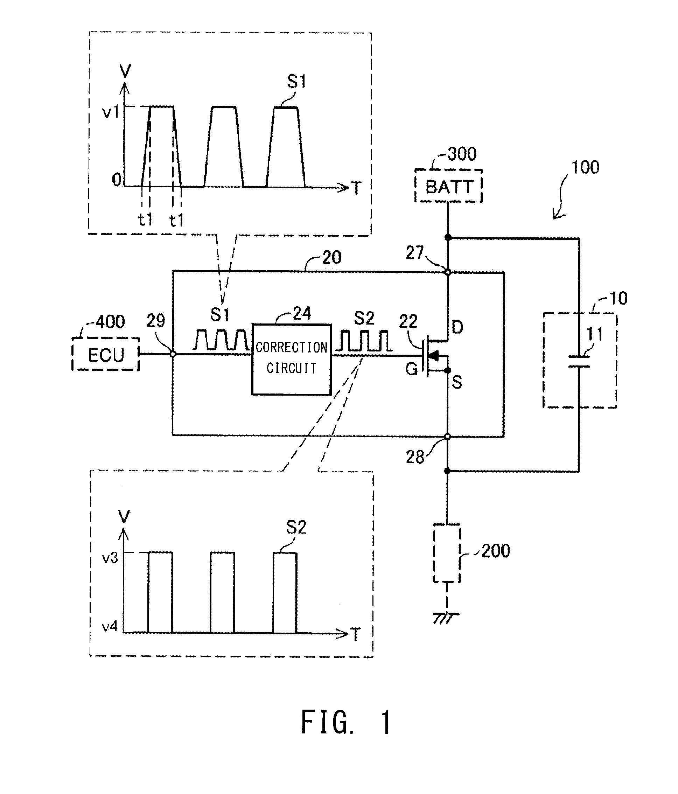

FIG. 1 is an electrical circuit diagram showing the configuration of an energization control apparatus according to one embodiment of the present invention. The energization control apparatus denoted by reference numeral 100 controls the supply and cutoff of electric power supplied to a glow plug 200 from a power supply 300 such as a battery on the basis of a control signal S1 supplied from an ECU (Electronic Control Unit) 400. The energization control apparatus 100 includes a switching circuit 20 and a power supply variation frequency shift circuit 10.

The switching circuit 20 includes a semiconductor switching element 22, a correction circuit 24, two input terminals 27 and 29, and an output terminal 28.

The semiconductor switching element 22 is a power semiconductor device, and, in the present embodiment, is composed of a MOS-FET (Metal-Oxide-Semiconductor Field-Effect Transistor). As shown in FIG. 1, the gate electrode of the semiconductor switching element 22 is connected to the correction circuit 24. The drain electrode of the semiconductor switching element 22 is connected to the input terminal 27, and the source electrode of the semiconductor switching element 22 is connected to the output terminal 28. The semiconductor switching element 22 controls the supply and cutoff of electric power supplied to the output terminal 28 from the input terminal 27 on the basis of a control signal S2 supplied from the correction circuit 24.

The correction circuit 24 is connected to the semiconductor switching element 22 and the input terminal 29. The correction circuit 24 corrects the control signal S1 supplied from the input terminal 29 in such a manner that its rise time and fall time become shorter, and outputs the corrected control signal S1 to the gate electrode of the semiconductor switching element 22 as the control signal S2. In the example of FIG. 1, a signal whose High voltage is v1 volt (V), whose Low voltage is 0 volt (V) and whose rise time and fall time are t1 (sec) is input to the correction circuit 24 as the control signal S1. The correction circuit 24 corrects the control signal S1 in such a manner that the rise time and fall time of the control signal S1 become shorter, whereby the control signal S2 whose High voltage is v3 volt (V), whose Low voltage is v4 volt (V) which is the potential of the source electrode of the semiconductor switch element 22, and whose rise time and fall time are substantially 0 (sec) is output. In the energization control apparatus 100 of the present embodiment, through the above-described correction of the control signal by the correction circuit 24, the amount of heat generation of the semiconductor switching element 22 is reduced, whereby malfunction of the semiconductor switching element 22 is restrained. Notably, a known correction circuit (driver) can be used as the correction circuit 24.

The power supply variation frequency shift circuit 10 is connected in parallel to the switching circuit 20 (the semiconductor switching element 22). In the present embodiment, the power supply variation frequency shift circuit 10 is composed of a capacitor 11, and is connected in parallel between the drain electrode and the source electrode of the semiconductor switching element 22. More specifically, one terminal of the capacitor 11 is connected to the input terminal 27 of the switching circuit 20, and the other terminal of the capacitor 11 is connected to the output terminal 28 of the switching circuit 20.

The power supply variation frequency shift circuit 10 (the capacitor 11) shifts to the low frequency side the noise generated as a result of switching operation of the semiconductor switching element 22. Due to the inductor component of a cable (harness) which connects the power supply 300 and the switching circuit 20, an abrupt variation (oscillation) of the power supply voltage occurs at the time of switching operation of the semiconductor switching element 22. The power supply variation frequency shift circuit 10 shifts the variation of the power supply voltage to the low frequency side by absorbing the variation by the capacitor 11. The capacitance of the capacitor 11 is set in advance in accordance with the current value and the amount of shift of noise to the low frequency side. For example, in the case where several 10s of ampere (A) to 100 ampere (A) flows and the variation (noise) of the power supply voltage is to be reduced to about one third or one fourth as will be described later, the capacitance of the capacitor 11 is set to about several µF. Accordingly, the capacitance of the capacitor 11 is very large as compared with the capacitance (about several pF to several nF) of a common capacitor used as a measure against external noise such as surge. In the present embodiment, a multilayer ceramic capacitor is employed for the capacitor 11.

Notably, in the present embodiment, the glow plug 200 is used as a damping resistor, whereby the above-mentioned variation (oscillation) of the power supply voltage is attenuated. The resistance of the glow plug 200 serving as a damping resistor is 1 ohm (Ω) or less.

The input terminal 27 is connected to the drain electrode of the semiconductor switching element 22. Also, the input terminal 27 is connected to the power supply 300 through a cable. The input terminal 29 is connected to the correction circuit 24. Also, the input terminal 29 is connected to the ECU 400 through a cable. The output terminal 28 is connected to the source electrode of the semiconductor switching element 22. Also, the output terminal 28 is connected to the glow plug 200 through a cable.

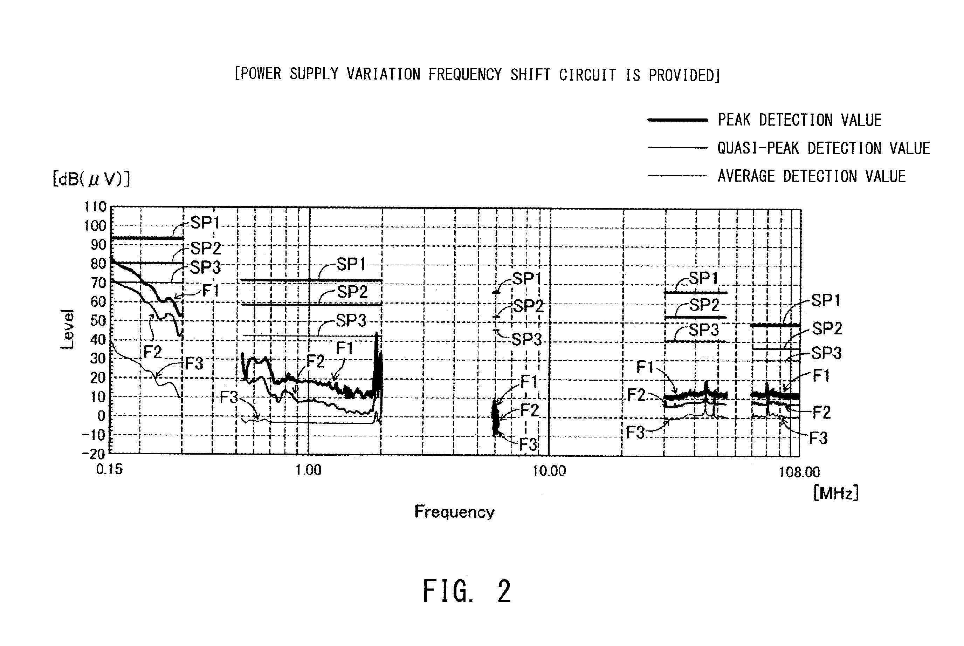

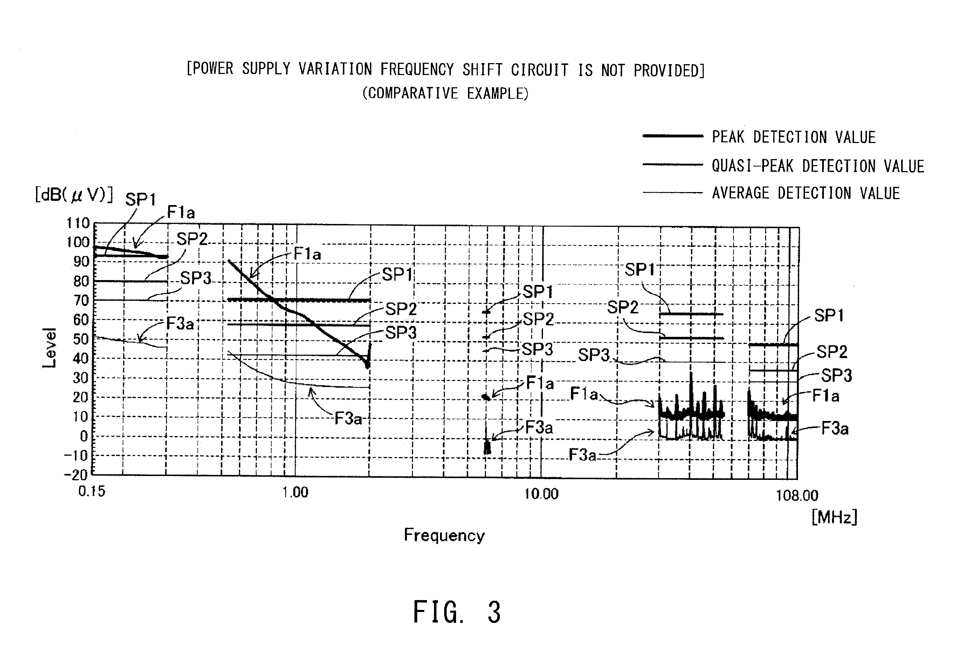

FIG. 2 is an explanatory graph showing the amount of variation (the level of transmission noise) of power supply voltage which occurs in the energization control apparatus 100 of the present embodiment. FIG. 3 is an explanatory graph showing the amount of variation (the level of transmission noise) of power supply voltage which occurs in an energization control apparatus of a comparative example. In FIGS. 2 and 3, the horizontal axis represents the frequency of noise (MHz), and the vertical axis represents the level of noise (dBµV). In FIGS. 2 and 3, the thickest line shows a specification value SP1 for the peak detection value of the variation, and the second thickest line shows a specification value SP2 for the quasi-peak detection value of the variation. The thinnest line shows a specification value SP3 for the average detection value of the variation. These specification values SP1, SP2, and SP3 are provided for each frequency band. When the energization control apparatus is used, the level of the variation of the power supply voltage must be lowered to a value lower than the specification values SP1 to SP3 in each frequency band. This is because if the level of the variation of the power supply voltage exceeds the specification values SP1 to SP3, the variation may affect other devices connected to the power supply 300. The energization control apparatus of the comparative example differs from the energization control apparatus 100 in the point that the power supply variation frequency shift circuit 10 is omitted. The remaining configuration is the same as that of the energization control apparatus 100.

The measured value F1 shown in FIG. 2 shows a measured peak detection value of the variation of the power supply voltage in the case where the above-described energization control apparatus 100 is used. The measured value F2 shows a measured quasi-peak detection value of the variation of the power supply voltage in the case where the above-described energization control apparatus 100 is used. The measured value F3 shows a measured average detection value of the variation of the power supply voltage in the case where the above-described energization control apparatus 100 is used.

The measured value F1a shown in FIG. 3 shows a measured peak detection value of the variation of the power supply voltage in the case where the energization control apparatus of the comparative example is used. The measured value F3a shown in FIG. 3 shows a measured average detection value of the variation of the power supply voltage in the case where the energization control apparatus of the comparative example is used.

As is apparent from comparison between FIGS. 2 and 3, as a result of use of the energization control apparatus 100, the peak detection value of the variation of the power supply voltage shifts to the low frequency side as a whole (in other words, while maintaining the level differences between the frequencies). For example, in the case of the energization control apparatus of the comparative example, the frequency at which the measured value F1a coincides with the specification value SP1 is about 0.8 MHz as shown in FIG. 3. In contrast, in the case of the energization control apparatus 100 of the embodiment, the frequency at which the measured value F1 coincides with the specification value SP1 is lower than the lower limit frequency (0.15 MHz) shown in FIG. 2.

As described above, by means of shifting the variation of the power supply voltage to the low frequency side, the level of the variation of the power supply voltage can be lowered in each frequency band. For example, as shown in FIGS. 2 and 3, in the frequency band in the vicinity of 0.5 MHz, the variation level is lowered from about 90 dBµV to about 30 dBµV; i.e., to one thousandth. Therefore, as shown in FIG. 2, the measured peak detection value F1 is lower than the specification value SP1 for the peak detection value in all the frequency bands (0.15 to 108.00 MHz) shown in FIG. 2. Similarly, the measured quasi-peak detection value F2 is lower than the specification value SP2 for the quasi-peak detection value in all the frequency bands. Also, the measured average detection value F3 is lower than the specification value SP3 for the average detection value in all the frequency bands. Accordingly, in all the frequency bands shown in FIG. 2, the variation is less likely to affect other devices (an FM radio or the ECU mounted on the vehicle) connected to the power supply 300.

In contrast, in the case where the energization control apparatus of the comparative example is used, as shown in FIG. 3, the measured value F1a exceeds the specification value SP1 in the frequency band of about 0.8 MHz or lower. Accordingly, the variation is more likely to affect other devices, such as the ECU, connected to the power supply 300. In recent years, the glow plug may be operated not only when a diesel engine is started, but also when the vehicle is operated. For example, in the case of a vehicle which has a filter (DPF) for capturing and burning soot contained in exhaust gas, in order to increase the temperature of the filter, the glow plug may be operated in a period during which the vehicle is operated. When the glow plug operates in the period during which the vehicle is operated, the energization control apparatus of the comparative example is likely to affect other devices, such as the ECU, connected to the power supply 300.

When the energization control apparatus 100 of the present embodiment is used, as described above, the variation of the power supply voltage is shifted to the low frequency side. As a result, the level of the variation of the power supply voltage can be lowered in all the frequency bands. Therefore, even when the glow plug 200 is operated in the period during which the vehicle is operated, the energization control apparatus 100 can prevent the variation of the power supply voltage from affecting the other devices connected to the power supply 300.

### A2. Another application example of the energization control apparatus 100:

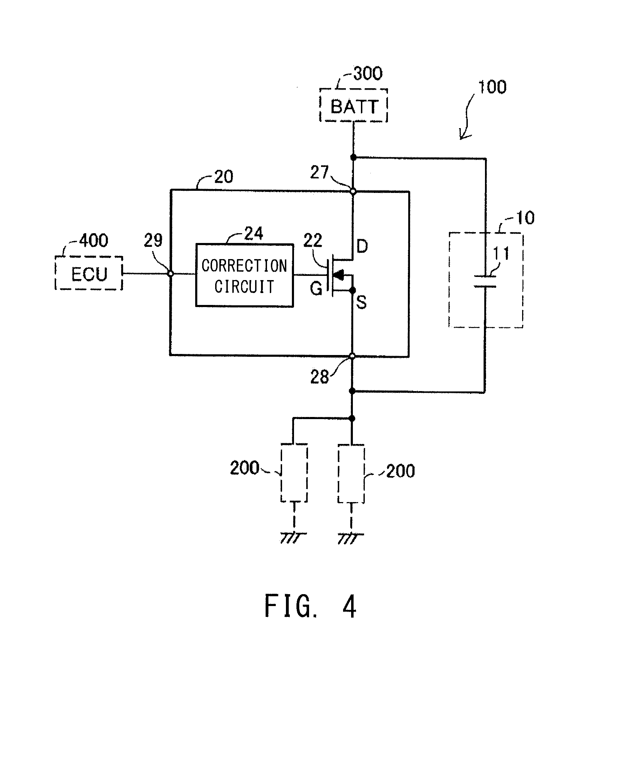

FIG. 4 is an explanatory diagram showing another application example of the energization control apparatus 100 of the first embodiment. In the example of FIG. 4, the energization control apparatus 100 is connected to two glow plugs 200. Specifically, the energization control apparatus 100 is connected in series to the two glow plug 200 which are connected in parallel to each other. In this application example, the energization control apparatus 100 controls the supply of electricity to one glow plug 200 and the supply of electricity to the other glow plug 200 at substantially the same timing. Notably, in place of the two glow plugs 200, three or more (any number of) glow plugs 200 may be connected.

In the above-described energization control apparatus 100 of the first embodiment, since the power supply variation frequency shift circuit 10 is connected in parallel to the semiconductor switching element 22, the variation of the power supply voltage due to the switching operation of the semiconductor switching element 22 can be shifted to the low frequency side by the capacitor 11 of the power supply variation frequency shift circuit 10. Therefore, the level of the variation of the power supply voltage can be lowered in each frequency band, whereby the influence of the variation on other devices connected to the power supply 300 can be suppressed. In addition, since the switching circuit 20 includes the correction circuit 24, the control signal S2 obtained by correcting the control signal S1 in such a manner that its rise time and fall time become shorter can be supplied to the semiconductor switching element 22. Therefore, the electric power consumed by the switching circuit 20 can be reduced, whereby the amount of heat generated by the switching circuit 20 can be reduced. In addition, malfunction of the semiconductor switching element 22 can be restrained. Also, since the glow plug 200 is used as a damping resistor, it is unnecessary to provide a damping resistor in the power supply variation frequency shift circuit 10. Therefore, an increase in the production cost of the energization control apparatus 100 can be suppressed.

### B. Second embodiment:

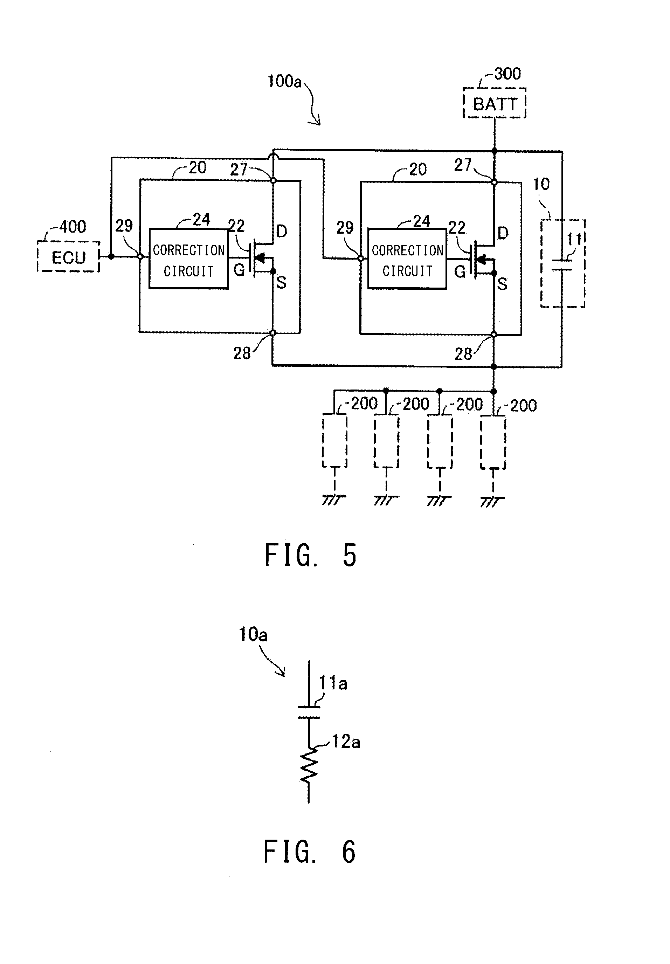

FIG. 5 is an electrical circuit diagram showing the configuration of an energization control apparatus 100a according to a second embodiment. The energization control apparatus 100a differs from the energization control apparatus 100 of the first embodiment shown in FIG. 1 in the point that the energization control apparatus 100a has two switching circuits 20 and is connected to four glow plugs 200. Since the remaining configuration of the energization control apparatus 100a of the second embodiment is the same as that of the energization control apparatus 100 of the first embodiment, the same constituent elements are denoted by the same reference numerals, and their description is omitted.

As shown in FIG. 5, the two switching circuits 20 and the power supply variation frequency shift circuit 10 are connected in parallel to one another. Specifically, the two input terminals 27 of the switching circuits 20 and one terminal of the capacitor 11 are connected to one another. The two output terminals 28 of the switching circuits 20 and the other terminal of the capacitor 11 are connected to one another. As shown in FIG. 5, the four glow plug 200 are connected in parallel to one another. Such parallel connection of the four glow plugs 200 can reduce the number of cables used for connection between the energization control apparatus 100a and the four glow plugs 200. However, since the four glow plugs 200 are connected in parallel, the total sum of the currents supplied to the four glow plugs 200 is larger as compared with that in the case where only one glow plug 200 is connected to the energization control apparatus 100a. Therefore, in the case where the switching circuit is realized by a single circuit as in the first embodiment, the mounting scale becomes large. In view of this, in the energization control apparatus 100a of the second embodiment, two switching circuits 20 are connected in parallel and driven simultaneously, whereby an increase in the circuit scale is suppressed while the supply control of large current is realized.

In the energization control apparatus 100a of the second embodiment having the above-described configuration, since the power supply variation frequency shift circuit 10 (the capacitor 11) is connected in parallel to the two switching circuit 20 (the two semiconductor switching elements 22), the energization control apparatus 100a of the second embodiment has the same effect as that of the energization control apparatus 100 of the first embodiment.

### C. Modifications:

### C1. Modification 1:

In each embodiment, the power supply variation frequency shift circuit 10 is composed of the capacitor 11. However, the present invention is not limited thereto. FIG. 6 is an explanatory diagram showing the configuration of a power supply variation frequency shift circuit in this modification. A power supply variation frequency shift circuit 10a shown in FIG. 6 includes a capacitor 11a and a resistor 12a connected in series to the capacitor 11a. Even in the case where this power supply variation frequency shift circuit 10a is used, an effect similar to that of each embodiment can be attained.

Also, one terminal of the power supply variation frequency shift circuit 10a of the above-described modification may be grounded instead of being connected to the output terminals 28 of the switching circuits 20. In this configuration, the resistor 12a functions as a damping resistor, and its resistance can be set to 1 ohm (Ω) or smaller.

Namely, the capacitor which generally shifts to the low frequency side the variation of the power supply voltage occurring when the semiconductor switching element 22 supplies or cuts off electric power may be used in the energization control apparatus of the present invention. Also, the capacitor connected in parallel to the semiconductor switching element 22; i.e., the capacitor connected in parallel between the input portion (the drain electrode) of the semiconductor switching element 22 and the output portion (the source electrode) of the semiconductor switching element 22, may be used in the energization control apparatus of the present invention.

### C2. Modification 2:

In each of the embodiments and the modification, the energization control apparatus 100, 100a is used to control the supply of electricity to the glow plug 200. However, the energization control apparatus 100, 100a may be used to control the supply of electricity to any device other than glow plugs, such as a heater

### C3. Modification 3:

In each of the embodiments and the modifications, the semiconductor switching element 22 is an MOS-FET. However, instead of the MOS-FET, any element (power device) such as a bipolar transistor or an IGBT may be used.

### C4. Modification 4:

In each of the embodiments and the modifications, the correction circuit 24 corrects the control signal S1 in such a manner that both the rise time and the fall time thereof become shorter. However, the control signal S1 may be corrected in such a manner that only one of the rise time and the fall time thereof becomes shorter. This configuration also can restrain malfunction of the semiconductor switching element 22 and suppress an increase in the amount of electric power consumed (the amount of heat generated) at the semiconductor switching element 22 as compared with the configuration in which the correction circuit 24 is omitted.

### C5. Modification 5:

In each of the embodiments and the modifications, the correction circuit 24 is provided. However, the correction circuit 24 may be omitted in the case where only the effect of suppressing the influence of noise on other devices must be obtained.

The present invention is not limited to the above-described embodiments and modifications and may be embodied in various other forms without departing from the spirit of the invention. For example, the technical features in the embodiments and modifications corresponding to the technical features in the modes described in "Summary of the Invention" can be appropriately replaced or combined in order to solve some of or all the foregoing problems or to achieve some of or all the foregoing effects. A technical feature which is not described as an essential feature in the present specification may be appropriately deleted.

### [Description of Reference Numerals and Symbols]

- 10, 10a: power supply variation frequency shift circuit
- 11, 11a: capacitor
- 12a: resistor
- 20: switching circuit
- 22: semiconductor switching element
- 24: correction circuit
- 27: input terminal
- 28 8: output terminal
- 29: input terminal
- 100, 100a: energization control apparatus
- 200: glow plug
- 300: power supply
- 400: ECU
- S1, S2: control signal
- F1, F2, F3, F1a, F2a, F3a: measured value
- SP1, SP2, SP3: specification value

## Claims

1. An energization control apparatus which has a semiconductor switching element disposed between a power supply and a glow plug and controlling the supply and cutoff of electric power from the power supply to the glow plug in accordance with a received control signal, further comprising a capacitor connected in parallel to the semiconductor switching element.

2. An energization control apparatus according to claim 1, further comprising a correction circuit, wherein the correction circuit corrects the control signal in such a manner that a rise time of the corrected control signal input to the semiconductor switching element becomes shorter than that of the control signal before the correction, or a fall time of the corrected control signal input to the semiconductor switching element becomes shorter than that of the control signal before the correction.

3. An energization control apparatus according to claim 1 or 2, wherein the semiconductor switching element and the capacitor are connected in series to a plurality of the glow plugs connected in parallel to one another.

4. An energization control apparatus according to any one of claims 1 to 3, further comprising a resistor which is connected in series to the capacitor and which has a resistance of 1 ohm or less.
